# EUROPÄISCHE PATENTANMELDUNG

(11) **EP 1 630 915 A2**
(43) Veröffentlichungstag der Anmeldung: **01.03.2006**
(21) Anmeldenummer: 05016464.9
(22) Anmeldetag: 28.07.2005
(51) Int. Cl.: H01S 5/227, H01S 5/343, H01S 5/40, H01L 33/00

(54) **Strahlungsemittierendes optoelektronisches Bauelement mit einer Quantentopfstruktur und Verfahren zu dessen Herstellung**

(30) Priorität: 08.02.2005 DE 102005005635; 31.08.2004 DE 102004042059
(71) Anmelder: Osram Opto Semiconductors GmbH, 93049 Regensburg (DE)
(72) Erfinder: Brückner, Peter, 88069 Tettnang (DE); Scholz, Ferdinand, 89075 Ulm (DE); Neubert, Barbara, 89075 Ulm (DE); Habel, Frank, 89075 Ulm (DE)
(74) Vertreter: Epping, Wilhelm

(57) **Zusammenfassung**

Bei einem strahlungsemittierenden optoelektronischen Bauelement mit einer aktiven Zone, die eine Quantentopfstruktur (5) aufweist, die mindestens ein erstes Nitridverbindungshalbleitermaterial enthält, ist die Quantentopfstruktur (5) auf mindestens einer Seitenfacette (9) einer nicht planaren Struktur (4), die mindestens ein zweites Nitridverbindungshalbleitermaterial enthält, aufgewachsen. Durch das Aufwachsen der Quantentopfstruktur (5) auf eine Seitenfacette (9) werden durch Gitterfehlanpassungen verursachte piezolelektrische Felder vorteilhaft verringert und die Homogenität der Quantentopfstruktur (5) verbessert.

## Beschreibung

Strahlungsemittierendes optoelektronisches Bauelement mit einer Quantentopfstruktur und Verfahren zu dessen Herstellung

Diese Patentanmeldung beansprucht die Priorität der deutschen Patentanmeldungen 102004042059.9 und 102005005635.0, deren Offenbarungsgehalt hiermit durch Rückbezug aufgenommen wird.

Die Erfindung betrifft ein strahlungsemittierendes optoelektronisches Bauelement nach dem Oberbegriff des Patentanspruchs 1 und ein Verfahren zur Herstellung eines strahlungsemittierenden optoelektronischen Bauelements nach dem Oberbegriff des Patentanspruchs 22.

Heterostrukturen und Quantenstrukturen aus Nitridverbindungshalbleitern werden in optoelektronischen Halbleiterbauelementen häufig verwendet, da sich mit diesen Materialien aufgrund ihrer großen elektronischen Bandlücke eine Strahlungsemission im kurzwelligen sichtbaren und im ultravioletten Spektralbereich realisieren lässt. In ternären oder quaternären Nitridverbindungshalbleitern, beispielsweise AlGaN, InGaN oder InAlGaN, kann die elektronische Bandlücke durch eine Variation der Zusammensetzung der Halbleitermaterialien variiert werden.

Anders als konventionelle Halbleiter, beispielsweise Phosphide oder Arsenide, kristallisieren Nitridverbindungshalbleiter gewöhnlich in der Wurzitstruktur. Die bevorzugte Wachstumsrichtung bei der epitaktischen Herstellung derartiger Halbleiterschichten stellt die c-Richtung ([0001]-Richtung) dar.

Bei der Herstellung von Heterostrukturen oder Quantenstrukturen von Nitridverbindungshalbleitern, bei der mehrere Schichten mit unterschiedlicher Materialzusammensetzung aufeinander abgeschieden werden, besteht das Problem, dass aufgrund der vergleichsweise großen Gitterkonstanten-Unterschiede der Nitridverbindungshalbleiter untereinander biaxiale Verspannungen auftreten, die zu großen piezoelektrischen Feldern führen. Solche piezoelektrischen Felder können ähnlich wie bei dem bekannten Quantum Confined Stark Effekt (QCSE) zu einer Verschiebung der Bandkanten des Leitungs- oder Valenzbands führen und zu einer räumlichen Trennung von beispielsweise durch optische Anregung erzeugten Elektronen und Löchern führen. Durch diese Ladungsträgertrennung wird die Rekombinationswahrscheinlichkeit und damit insbesondere auch die Wahrscheinlichkeit für die stimulierte Emission von Licht reduziert.

Zudem werden die optoelektronischen Eigenschaften bei Nitridverbindungshalbleitern, die Indium enthalten, außer von hohen piezoelektrischen Feldern oftmals auch von räumlichen Fluktuationen der Zusammensetzung negativ beeinflusst, was sich zum Beispiel in hohen Ladungsträgerlebensdauern, großen Lumineszenz-Linienbreiten und einer großen Wellenlängenverschiebung zwischen Absorption und Emission äußert. Eine räumliche Fluktuation der Zusammensetzung des Halbleitermaterials kann insbesondere durch eine räumliche Variation des Indiumanteils in einem InGaN-Halbleiter entstehen. Ursache dafür sind vergleichweise niedrige Wachstumstemperaturen von etwa 700°C bis 800°C bei der epitaktischen Herstellung von InGaN-Schichten, die durch die niedrige Zersetzungstemperatur von InN im Vergleich zu GaN und AlN bedingt sind.

Durch die hohen piezoelektrischen Felder und die Fluktuationen der Zusammensetzung wird die Herstellung von strahlungsemittierenden optoelektronischen Bauelementen, beispielsweise LEDs oder Laserdioden, auf der Basis von Nitridverbindungshalbleitern erschwert.

Der Erfindung liegt die Aufgabe zugrunde, ein verbessertes strahlungsemittierendes optoelektronisches Bauelement mit einer Quantentopfstruktur auf der Basis eines Nitridverbindungshalbleiters anzugeben, das sich insbesondere durch vergleichsweise geringe piezoelektrische Felder und/oder geringe räumliche Kompositionsfluktuationen innerhalb der Quantentopfstruktur auszeichnet. Ferner soll ein vorteilhaftes Verfahren zur Herstellung eines derartigen strahlungsemittierenden Bauelements angegeben werden.

Diese Aufgabe wird durch ein strahlungsemittierendes optoelektronisches Bauelement mit den Merkmalen des Patentanspruchs 1 beziehungsweise durch ein Verfahren mit den Merkmalen des Patentanspruchs 22 gelöst. Vorteilhafte Ausgestaltungen und Weiterbildungen der Erfindung sind Gegenstand der abhängigen Ansprüche.

Bei einem strahlungsemittierenden optoelektronischen Bauelement mit einer aktiven Zone, die eine Quantentopfstruktur aufweist, welche mindestens ein erstes Nitridverbindungshalbleitermaterial enthält, ist gemäß der Erfindung die Quantentopfstruktur auf mindestens einer Seitenfacette einer nicht planaren Struktur, die mindestens ein zweites Nitridverbindungshalbleitermaterial enthält, aufgewachsen.

Das Aufwachsen einer Quantentopfstruktur aus Nitridverbindungshalbleitern auf eine Seitenfacette einer nicht planaren Struktur hat den Vorteil, dass die Seitenfacetten Kristallflächen darstellen, bei denen aufgrund des anisotropen Zusammenhangs zwischen Verspannung und Piezo-Effekt geringere piezoelektrische Felder auftreten, als es zum Beispiel bei der herkömmlichen Epitaxie von Quantentopfstrukturen auf einer c-Fläche eines Substrats der Fall wäre. Auf diese Weise werden durch Verspannungen erzeugte piezoelektrische Felder verringert und die in der Beschreibungseinleitung erwähnten nachteiligen Effekte piezoelektrischer Felder auf die optischen Eigenschaften des optoelektronischen Bauelements vermindert.

Die Bezeichnung Quantentopfstruktur umfasst im Rahmen der Erfindung jegliche Struktur, in der die Ladungsträger durch Einschluss (Confinement) eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen. Die Quantentopfstruktur kann beispielsweise eine Mehrzahl von Quantenfilmen und zwischen den Quantenfilmen angeordnete Barriereschichten enthalten.

Die Seitenfacette ist bevorzugt eine {1-101}-Kristallfläche, eine {11-20}-Kristallfläche, eine {1-100}-Kristallfläche oder eine {11-22}-Kristallfläche, und insbesondere keine {0001}-Kristallfläche.

Besonders vorteilhaft ist die Erfindung für Quantentopfstrukturen, die ein Indium enthaltendes III-V-Nitridverbindungshalbleitermaterial umfassen, insbesondere ein Halbleitermaterial mit der Zusammensetzung In_{1-x-y}AlₓGa_{y}N mit 0 ≤ x ≤ 1, 0 ≤ y ≤ 1 und x + y < 1.

Da sich die Problematik der piezoelektrischen Felder bei der herkömmlichen Epitaxie mit zunehmendem Indium-Anteil verstärkt, ist die Erfindung besonders vorteilhaft für Halbleitermaterialien mit der zuvor angegebenen Zusammensetzung, bei denen für den Indium-Anteil gilt: 1 - x - y > 0,1, besonders bevorzugt 1 -x - y > 0,2.

Bei derartigen Indium enthaltenden Nitridverbindungshalbleitern hat das Aufwachsen der Quantentopfstruktur auf Seitenfacetten neben der Vermeidung piezoelektrischer Felder auch den Vorteil, dass die bei der herkömmlichen epitaktischen Herstellung oftmals auftretenden Fluktuationen des Indium-Anteils aufgrund veränderter Oberflächen-Migrationseigenschaften auf den Seitenfacetten vermindert sind.

Da die Emissionswellenlänge von optoelektronischen Bauelementen auf der Basis von InAlGaN-Halbleitern mit zunehmendem Indium-Anteil zu größeren Wellenlängen hin verschoben wird, und die Erfindung aus den zuvor genannten Gründen die Herstellung von qualitativ hochwertigen Quantentopfstrukturen mit hohem Indium-Anteil ermöglicht, sind vorteilhaft optoelektronische Bauelemente, insbesondere auch Laserdioden, realisierbar, bei denen die emittierte Strahlung eine Wellenlänge von mehr als 420 nm, besonders bevorzugt mehr als 430 nm, aufweist. Insbesondere umfasst die Erfindung Laserdioden auf der Basis von In_{1-x-y}AlₓGa_{y}N, die im blauen oder grünen Spektralbereich emittieren.

Die nicht planare Struktur einschließlich der darauf aufgebrachten Quantentopfstruktur ist vorteilhaft mit einer Deckschicht überwachsen. Die Dicke der Deckschicht wird bevorzugt so gewählt, dass sie eine planare Oberfläche aufweist. Die Deckschicht dient einerseits zum Schutz der Quantentopfstruktur vor Umgebungseinflüssen und anderseits auch zur Stromeinprägung in das optoelektronische Bauelement. Um eine Stromeinprägung in die aktive Zone zu ermöglichen, sind die nicht planare Struktur und die Deckschicht bevorzugt aus elektrisch leitend dotierten Halbleitermaterialien gebildet, die einen entgegengesetzten Leitungstyp aufweisen. Beispielsweise kann die nicht planare Struktur n-dotiert sein und die Deckschicht p-dotiert, oder alternativ die nicht planare Struktur p-dotiert und die Deckschicht n-dotiert.

Die nicht planare Struktur umfasst bevorzugt einen oder mehrere Streifen. Der oder die Streifen können quer zu ihrer Längsrichtung beispielsweise eine dreieckige, trapezförmige oder rechteckige Querschnittsfläche aufweisen.

In der Streifenlängsrichtung werden der oder die Streifen bevorzugt durch eine erste Endfläche und eine zweite Endfläche begrenzt. Die Endflächen sind vorzugsweise parallel zueinander und können so vorteilhaft einen Laserresonator ausbilden. Die beiden Endflächen des Streifens können beispielsweise durch einen Ätzprozess, insbesondere einen Trockenätzprozess, erzeugt sein. Besonders vorteilhaft ist es, wenn die erste Endfläche und die zweite Endfläche durch epitaktisches Wachstum erzeugte parallele Kristallflächen sind. Auf diese Weise kann der mit dem Ätzprozess verbundene Herstellungsaufwand vorteilhaft entfallen.

In einer bevorzugten Ausführungsform der Erfindung ist eine Mehrzahl von parallel zueinander angeordneten Streifen vorgesehen. Dabei kann ein Laserresonator wie zuvor beschrieben in der Längsrichtung der Streifen angeordnet sein oder alternativ auch senkrecht zu der Längsrichtung der Streifen. Im letzt genannten Fall können die parallel zueinander angeordneten Streifen derart periodisch angeordnet sein, dass sie eine DFB-Laserstruktur ausbilden.

Anstelle von Streifen kann die nicht planare Struktur bei der Erfindung auch andere geometrische Formen aufweisen, insbesondere hexagonale Strukturen wie beispielsweise sechseckige Pyramiden oder Pyramidenstümpfe. Weiterhin sind auch zylinderförmige Strukturen möglich.

Die aktive Zone ist bevorzugt zwischen zwei Wellenleiterschichten angeordnet. Die Wellenleiterschichten können beispielsweise AlGaN oder ein anderes Material, das einen höheren Brechungsindex als die aktive Zone aufweist, enthalten. Beispielsweise kann die nicht planare Struktur auf eine erste Wellenleiterschicht aufgebracht sein und die zweite Wellenleiterschicht auf die Deckschicht, die vorzugsweise eine planare Oberfläche aufweist, aufgebracht sein.

Das optoelektronische Bauelement ist bevorzugt eine Laserdiode. Die Erfindung umfasst aber auch alle Formen von Lumineszenzdioden, die Quantentopfstrukturen enthalten, beispielsweise Leuchtdioden (LEDs).

Bei einem erfindungsgemäßen Verfahren zur Herstellung eines strahlungsemittierenden optoelektronischen Bauelements wird eine Epitaxieoberfläche bereitgestellt, auf die eine Maskenschicht aufgebracht wird. Auf der mit der Maskenschicht versehenen Epitaxieoberfläche wird eine nicht planare Struktur durch Aufwachsen eines Nitridverbindungshalbleitermaterials hergestellt. Auf mindestens eine Seitenfacette der Quantentopfstruktur wird eine nicht planare Struktur aufgewachsen und nachfolgend eine Deckschicht aufgebracht.

Die Epitaxieoberfläche kann die Oberfläche eines Substrats, beispielsweise eines Saphirsubstrats, sein. Um das nachfolgende epitaktische Aufwachsen der nicht planaren Struktur zu erleichtern, wird bevorzugt die Oberfläche einer Nitridverbindungshalbleiterschicht, die beispielsweise zuvor auf einem Substrat aufgewachsen wurde, als Epitaxieoberfläche verwendet. Besonders bevorzugt stimmt das Material der Nitridverbindungshalbleiterschicht mit dem der nicht planaren Struktur überein. Selbstverständlich kann die Epitaxieoberfläche auch die Oberfläche einer Schichtenfolge aus mehreren Halbleiterschichten sein, die weitere funktionelle Halbleiterschichten, beispielsweise eine Wellenleiterschicht, enthält.

Die Maskenschicht ist bevorzugt aus einem Siliziumoxid oder einem Siliziumnitrid oder einem anderen Material, das das direkte epitaktische Aufwachsen eines Nitridverbindungshalbleiters verhindert, gebildet. Weiterhin enthält die Maskenschicht mindestens eine Öffnung, in der die Epitaxieoberfläche zum Aufwachsen der nicht planaren Struktur des Nitridverbindungshalbleitermaterials freigelegt ist.

Vorzugsweise enthält die Maskenschicht eine Mehrzahl parallel angeordneter streifenförmiger Öffnungen. Die streifenförmigen Öffnungen weisen vorteilhaft eine Breite zwischen 100 nm und 10 *µ*m auf. Der gegenseitige Abstand der streifenförmigen Öffnungen beträgt bevorzugt zwischen 100 nm und 200 *µ*m.

Das Aufwachsen der nicht planaren Struktur und der Quantentopfstruktur auf die mit der Maskenschicht versehene Epitaxieoberfläche erfolgt vorzugsweise mittels metallorganischer Glasphasenepitaxie (MOVPE). Dieses Abscheideverfahren ist insbesondere für das Aufwachsen der Quantentopfstruktur auf die Seitenfacetten der nicht planaren Struktur vorteilhaft, da es im Vergleich zu gerichteten Abscheideverfahren, beispielsweise der Molekularstrahlepitaxie, ein selektives Wachstum auf den schrägen und/oder senkrechten Flächen ermöglicht, d.h. dass insbesondere kein Halbleitermaterial auf den maskierten Bereichen nukleiert.

Auf die nicht planare Struktur einschließlich der Quantentopfstruktur wird bevorzugt eine derart dicke Deckschicht aufgebracht, dass sie eine planare Oberfläche aufweist. Die dazu erforderliche Dicke hängt insbesondere von der Höhe der nicht planaren Struktur, die beispielsweise durch eine Variation der Abstände oder der Breite der Streifen beeinflusst werden kann, ab. Durch eine planare Deckschicht wird das Aufbringen einer oder mehrerer weiterer Halbleiterschichten, beispielsweise einer Wellenleiterschicht oder einer Schicht zur elektrischen Kontaktierung des optoelektronischen Bauelements, erleichtert.

Die Erfindung wird im folgenden anhand von Ausführungsbeispielen im Zusammenhang mit den Figuren 1 bis 9 näher erläutert.

Es zeigen:
- Figur 1: eine schematische Darstellung eines Querschnitts durch ein erstes Ausführungsbeispiel eines erfindungsgemäßen optoelektronischen Bauelements,
- Figur 2: eine schematische Darstellung eines Querschnitts durch ein Ausführungsbeispiel einer Quantentopfstruktur eines erfindungsgemäßen optoelektronischen Bauelements,
- Figur 3: eine schematische Darstellung eines Querschnitts durch ein zweites Ausführungsbeispiel eines erfindungsgemäßen optoelektronischen Bauelements,
- Figur 4: eine schematische perspektivische Darstellung eines dritten Ausführungsbeispiels eines erfindungsgemäßen optoelektronischen Bauelements,
- Figur 5: eine schematische Darstellung einer Aufsicht auf ein Ausführungsbeispiel einer Maskenschicht, die bei einem erfindungsgemäßen Verfahren zur Herstellung eines optoelektronischen Bauelements verwendet wird,
- Figur 6: eine schematische perspektivische Darstellung eines vierten Ausführungsbeispiels eines optoelektronischen Bauelements gemäß der Erfindung,
- Figur 7: eine schematische perspektivische Darstellung eines fünften Ausführungsbeispiels eines optoelektronischen Bauelements gemäß der Erfindung,
- Figur 8: eine schematische perspektivische Darstellung eines sechsten Ausführungsbeispiels eines optoelektronischen Bauelements gemäß der Erfindung, und
- Figur 9: eine schematische perspektivische Darstellung eines siebten Ausführungsbeispiels eines optoelektronischen Bauelements gemäß der Erfindung.

Gleiche oder gleichwirkende Elemente sind in den Figuren mit den gleichen Bezugszeichen versehen.

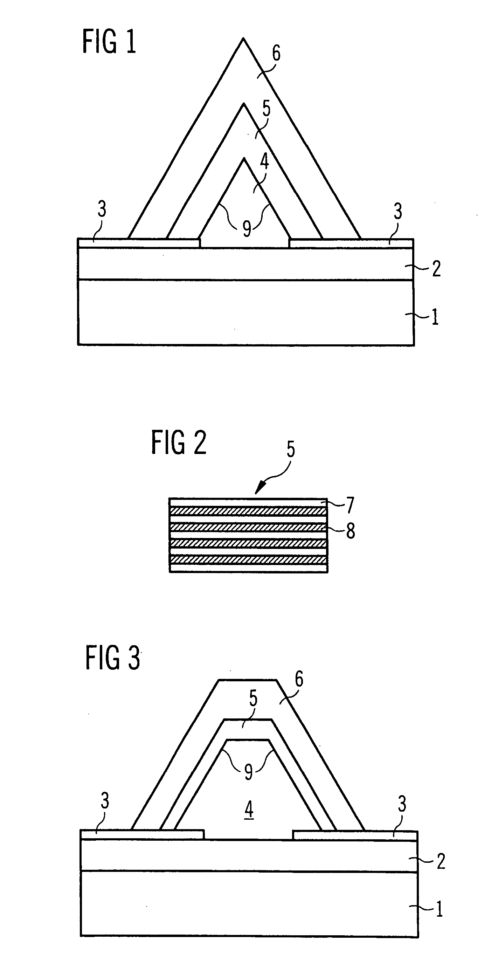

Das in Figur 1 dargestellte erste Ausführungsbeispiel eines optoelektronischen Bauelements gemäß der Erfindung enthält ein Substrat 1, das beispielsweise ein Saphir-Substrat ist. Auf das Substrat 1 ist eine Nitridverbindungshalbleiterschicht 2 aufgebracht, beispielsweise eine GaN-Schicht. Auf Teilbereiche der Halbleiterschicht 2 ist eine Maskenschicht 3 aufgebracht, die beispielsweise ein Siliziumoxid oder ein Siliziumnitrid enthält.

In den nicht von der Maskenschicht 3 bedeckten Teilbereichen der Halbleiterschicht 2 ist eine nicht planare Struktur 4 aus einem Nitridverbindungshalbleitermaterial aufgewachsen. Die nicht planare Struktur 4 kann beispielsweise aus dem gleichen Halbleitermaterial gebildet sein wie die Halbleiterschicht 2. Insbesondere können die Halbleiterschicht 2 und/oder die nicht planare Struktur 4 aus einem n-dotierten Nitridverbindungshalbleiter, zum Beispiel aus Si-dotierten GaN gebildet sein.

Die Form der nicht planaren Struktur 4 kann durch die Struktur der Maske und die Wachstumsbedingungen beim Aufwachsen des Nitridverbindungshalbleitermaterials, insbesondere durch eine Variation der Wachstumstemperatur, beeinflusst werden. Bei dem in Figur 1 gezeigten Ausführungsbeispiel weist die nicht planare Struktur 4 eine dreieckige Querschnittsfläche auf.

Auf die Seitenfacetten 9 der nicht planaren Struktur 4 ist eine Quantentopfstruktur 5 aufgewachsen. Die Quantentopfstruktur 5 kann insbesondere Quantenfilme aus InGaN enthalten. Durch das Aufwachsen der Quantentopfstruktur 5 auf die Seitenfacetten 9 werden piezoelektrische Felder im Vergleich zur herkömmlichen Epitaxie, die üblicherweise auf {0001}-Kristallflächen erfolgt, vorteilhaft verringert.. Besonders vorteilhaft ist es dabei, wenn die Seitenfacetten 9 eine {1-101}-Kristallfläche, eine {11-20}-Kristallfläche, eine {1-100}-Kristallfläche oder eine {11-22}-Kristallfläche sind.

Auf die Quantentopfstruktur 5 ist vorzugsweise eine Deckschicht 6 aufgebracht, bei der es sich insbesondere um eine p-dotierte Halbleiterschicht, beispielsweise mit Mg dotiertes GaN handeln kann. Dadurch, dass die Deckschicht 6 den entgegengesetzten Leitungstyp wie die nicht planare Struktur 4 aufweist, kann ein Strom in die Quantentopfstruktur 5 eingeprägt werden. Zur Kontaktierung des optoelektronischen Bauelements können beispielsweise Kontakte (nicht dargestellt) auf die Deckschicht 6 und auf Teilbereiche der Halbleiterschicht 2 aufgebracht werden.

Die Quantentopfstruktur 5 kann Quantentröge, Quantendrähte oder Quantenpunkte enthalten. Vorzugsweise enthält sie, wie in Figur 2 schematisch dargestellt, eine Mehrzahl von Barriereschichten 7, beispielsweise aus GaN, mit dazwischenliegenden Quantenfilmen 8, beispielsweise aus InGaN.

Bei dem in Figur 3 dargestellten Ausführungsbeispiel eines optoelektronischen Bauelements gemäß der Erfindung weist die nicht planare Struktur 4 eine trapezförmige Querschnittschnittsfläche auf. Alternativ kann beispielsweise auch ein rechteckiger Querschnitt für die nicht planare Struktur 4 vorgesehen sein. Ansonsten entspricht das in der Figur 3 dargestellte Ausführungsbeispiel im wesentlichen dem in Figur 1 dargestellten Ausführungsbeispiel.

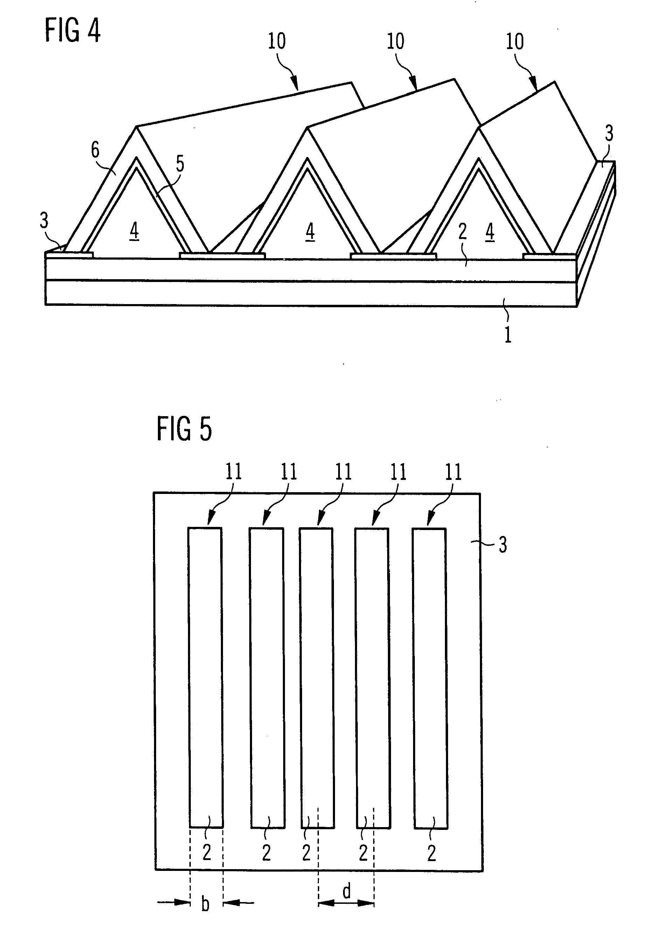

Bei dem in Figur 4 dargestellten Ausführungsbeispiel der Erfindung weist die nicht planare Struktur 4 eine Mehrzahl von parallel angeordneten Streifen 10 mit jeweils einer dreieckigen Querschnittsfläche auf. Anstelle der in der Figur 4 dargestellten drei Streifen 10 kann ein optoelektronisches Bauelement gemäß der Erfindung selbstverständlich auch eine größere Anzahl derartiger Streifen umfassen, um insbesondere eine hohe Intensität der emittierten Strahlung zu erzielen.

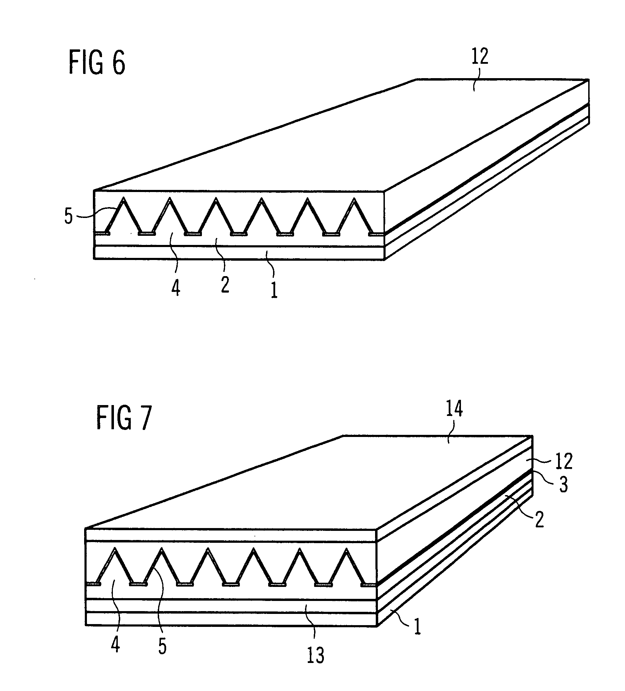

In Figur 5 ist eine Maskenschicht 3 dargestellt, die bei einem Verfahren zur Herstellung eines optoelektronischen Bauelements gemäß der Erfindung verwendet werden kann. Die Maskenschicht 3 weist eine Mehrzahl von streifenförmigen parallel angeordneten Öffnungen 11 auf. Die streifenförmigen Öffnungen können mit an sich bekannten Strukturierungsverfahren, wie beispielsweise Photolithographie, hergestellt werden und weisen vorzugsweise eine Breite b zwischen 100 nm und 10 *µ*m und einen gegenseitigen Abstand d zwischen 100 nm und 200 *µ*m auf. In den Öffnungen 11 der Maskenschicht ist das Halbleitermaterial 2 freigelegt, auf dem die nicht planare Struktur 4 epitaktisch aufgewachsen werden kann.

Bei dem in Figur 6 dargestellten Ausführungsbeispiel eines optoelektronischen Bauelements gemäß der Erfindung ist eine Deckschicht 12 aufgebracht, die eine planare Oberfläche aufweist. Eine Planarisierung der Deckschicht kann dadurch erzielt werden, dass die Deckschicht mit einer ausreichenden Dicke abgeschieden wird. Die dazu erforderliche Dicke kann insbesondere durch eine Verringerung der Streifenbreiten und der Abstände der Streifen reduziert werden.

Eine planare Deckschicht 12 ist insbesondere dann vorteilhaft, wenn, wie bei dem in Figur 7 dargestellten Ausführungsbeispiel, die Einbettung der aus der Quantentopfstruktur 5 gebildeten aktiven Zone in zwei Wellenleiterschichten 13, 14 vorgesehen ist. Das in Figur 7 dargestellte Ausführungsbeispiel enthält eine erste Wellenleiterschicht 13, die auf dem Substrat 1 abgeschieden ist, wobei auf die Wellenleiterschicht 13 die Halbleiterschicht 2 aufgebracht ist, auf der die nicht planare Struktur 4 aufgewachsen ist. Eine zweite Wellenleiterschicht 14 ist auf die planare Deckschicht 12 aufgebracht. Durch den aus den Wellenleiterschichten 13, 14 gebildeten Wellenleiter wird die von der Quantentopfstruktur 5 emittierte Strahlung in der Ebene parallel zu den Wellenleiterschichten 13, 14 geführt und somit eine vergleichsweise hohe Emission des optoelektronischen Bauelements in lateraler Richtung erreicht.

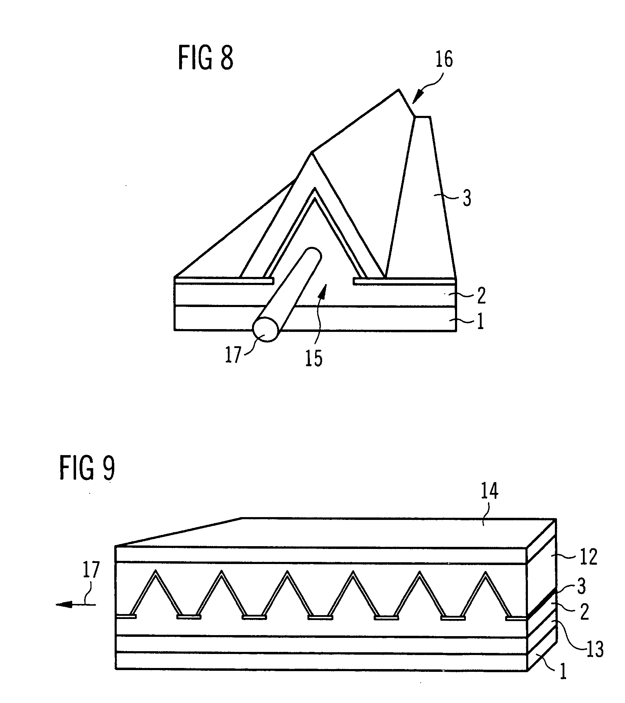

Die Figur 8 zeigt ein strahlungsemittierendes optoelektronisches Bauelement gemäß der Erfindung, bei dem es sich um eine Laserdiode handelt. Der Laserresonator wird durch zwei Endflächen 15, 16 eines Streifens 10 ausgebildet. Die Laserdiode emittiert Laserstrahlung 17 parallel zur Längsrichtung des Streifens 10. Die beiden parallelen Endflächen 15, 16 können beispielsweise durch einen Ätzprozess, insbesondere einen Trockenätzprozess, hergestellt sein. Vorteilhaft kann es sich bei den Endflächen 15, 16 aber auch um parallele Kristallflächen handeln, die direkt beim epitaktischen Aufwachsen der nicht planaren Struktur 4 erzeugt werden. Der Ätzprozess kann in diesem Fall vorteilhaft entfallen, wodurch der Herstellungsaufwand reduziert wird. Selbstverständlich können auch mehrere Streifen 10 nebeneinander angeordnet sein, um eine Mehrfachstrahl-Laserdiode zu erzeugen.

Im Gegensatz zu dem in Figur 8 dargestellten Ausführungsbeispiel kann ein Laserresonator auch quer zu einer Längsrichtung der Streifen 10 angeordnet sein.

Beispielsweise sind bei dem in Figur 9 dargestellten Ausführungsbeispiel mehrere Streifen 10 in der Richtung senkrecht zur Längsrichtung der Streifen derart periodisch angeordnet, dass sie eine DFB-Laserstruktur ausbilden. Laserstrahlung 17 wird in diesem Fall also senkrecht zur Längsrichtung der Streifen 10 emittiert. Wie bei dem zuvor im Zusammenhang mit der Figur 7 beschriebenen optoelektronischen Bauelement ist auch bei diesem Bauelement die Einbettung der aktiven Zone in Wellenleiterschichten 13, 14, vorteilhaft.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Strahlungsemittierendes optoelektronisches Bauelement mit einer aktiven Zone, die eine mindestens ein erstes Nitridverbindungshalbleitermaterial enthaltende Quantentopfstruktur (5) aufweist,
**dadurch gekennzeichnet, dass**
die Quantentopfstruktur (5) auf mindestens einer Seitenfacette (9) einer nicht planaren Struktur (4), die mindestens ein zweites Nitridverbindungshalbleitermaterial enthält, aufgewachsen ist.

2. Strahlungsemittierendes optoelektronisches Bauelement nach Anspruch 1,
**dadurch gekennzeichnet, dass**
die Quantentopfstruktur (5) eine Mehrzahl von Quantentfilmen (8) und zwischen den Quantenfilmen (8) angeordnete Barriereschichten (7) enthält.

3. Strahlungsemittierendes optoelektronisches Bauelement nach Anspruch 1 oder 2,
**dadurch gekennzeichnet, dass**
die Seitenfacette (9) eine Kristallfläche ist, die keine {0001}-Kristallfläche ist.

4. Strahlungsemittierendes optoelektronisches Bauelement nach einem der vorhergehenden Ansprüche,
**dadurch gekennzeichnet, dass**
die Seitenfacette (9) eine (1-101)-Kristallfläche, eine {11-20}-Kristallfläche, eine {1-100}-Kristallfläche oder eine {11-22}-Kristallfläche ist.

5. Strahlungsemittierendes optoelektronisches Bauelement nach einem der vorhergehenden Ansprüche,
**dadurch gekennzeichnet, dass**
die Quantentopfstruktur (5) als erstes Nitridverbindungshalbleitermaterial In_{1-x-y}AlₓGa_{y}N mit 0≤x≤1, 0≤y≤1 und x+y<1 enthält.

6. Strahlungsemittierendes optoelektronisches Bauelement nach Anspruch 5,
**dadurch gekennzeichnet, dass**
1-x-y ≥ 0,1 ist.

7. Strahlungsemittierendes optoelektronisches Bauelement nach einem der vorhergehenden Ansprüche,
**dadurch gekennzeichnet, dass**
die emittierte Strahlung (17) eine Wellenlänge von 420 nm oder größer aufweist.

8. Strahlungsemittierendes optoelektronisches Bauelement nach einem der vorhergehenden Ansprüche,
**dadurch gekennzeichnet, dass**
die nicht planare Struktur (4) einschließlich der darauf aufgebrachten Quantentopfstruktur (5) mit einer Deckschicht (6, 12) überwachsen ist.

9. Strahlungsemittierendes optoelektronisches Bauelement nach Anspruch 8,
**dadurch gekennzeichnet, dass**
die Deckschicht (12) eine planare Oberfläche aufweist.

10. Strahlungsemittierendes optoelektronisches Bauelement nach Anspruch 8 oder 9,
**dadurch gekennzeichnet, dass**
die nicht planare Struktur (4) und die Deckschicht (6, 12) aus elektrisch leitenden Halbleitermaterialien gebildet sind, die einen entgegengesetzten Leitungstyp aufweisen.

11. Strahlungsemittierendes optoelektronisches Bauelement nach einem der vorhergehenden Ansprüche,
**dadurch gekennzeichnet, dass**
die nicht planare Struktur (4) eine Pyramiden- oder Pyramidenstumpfstruktur, eine zylinderförmige Struktur oder einen oder mehrere Streifen (10) umfasst.

12. Strahlungsemittierendes optoelektronisches Bauelement nach Anspruch 11,
**dadurch gekennzeichnet, dass**
der Streifen (10) quer zu einer Streifenlängsrichtung eine dreieckige, trapezförmige oder rechteckige Querschnittsfläche aufweist.

13. Strahlungsemittierendes optoelektronisches Bauelement nach einem der Ansprüche 11 oder 12,
**dadurch gekennzeichnet, dass**
der Streifen (10) in einer Streifenlängsrichtung durch eine erste Endfläche (15) und eine zweite Endfläche (16) begrenzt wird, die parallel zueinander sind.

14. Strahlungsemittierendes optoelektronisches Bauelement nach Anspruch 13,
**dadurch gekennzeichnet, dass**
die parallelen Endflächen (15, 16) einen Laserresonator ausbilden.

15. Strahlungsemittierendes optoelektronisches Bauelement nach Anspruch 13 oder 14,
**dadurch gekennzeichnet, dass**
die erste Endfläche (15) und die zweite Endfläche (16) durch epitaktisches Wachstum erzeugte Kristallflächen sind.

16. Strahlungsemittierendes optoelektronisches Bauelement nach einem der Ansprüche 11 bis 15,
**dadurch gekennzeichnet, dass**
eine Mehrzahl von parallel zueinander angeordneten Streifen (10) vorgesehen ist.

17. Strahlungsemittierendes optoelektronisches Bauelement nach einem der Ansprüche 11 oder 12,
**dadurch gekennzeichnet, dass**
eine Mehrzahl von parallel zueinander angeordneten Streifen (10) vorgesehen ist und ein Laserresonator in einer Richtung senkrecht zu einer Längsrichtung der Streifen (10) ausgebildet ist.

18. Strahlungsemittierendes optoelektronisches Bauelement nach Anspruch 17,
**dadurch gekennzeichnet, dass**
die parallel zueinander angeordneten Streifen (10) derart periodisch angeordnet sind, dass sie eine DFB-Laserstruktur ausbilden.

19. Strahlungsemittierendes optoelektronisches Bauelement nach einem der vorhergehenden Ansprüche,
**dadurch gekennzeichnet, dass**
die aktive Zone zwischen zwei Wellenleiterschichten (13, 14) angeordnet ist.

20. Strahlungsemittierendes optoelektronisches Bauelement nach Anspruch 19,
**dadurch gekennzeichnet, dass**
die Wellenleitererschichten (13, 14) AlGaN enthalten.

21. Strahlungsemittierendes optoelektronisches Bauelement nach einem der vorhergehenden Ansprüche,
**dadurch gekennzeichnet, dass**
das optoelektronische Bauelement eine Laserdiode ist.

22. Verfahren zur Herstellung eines strahlungsemittierenden optoelektronischen Bauelements nach einem der vorhergehenden Ansprüche,
**gekennzeichnet durch** die Verfahrensschritte:
a) Bereitstellen einer Epitaxieoberfläche,
b) Aufbringen einer Maskenschicht (3) auf die Epitaxieoberfläche,
c) Herstellen einer nicht planaren Struktur (4) **durch** Aufwachsen eines Nitridverbindungshalbleitermaterials auf die mit der Maskenschicht (3) versehene Epitaxieoberfläche,
d) Aufwachsen einer Quantentopfstruktur (5) auf mindestens eine Seitenfacette (9) der nicht planaren Struktur (4) und
e) Aufwachsen einer Deckschicht (6, 12).

23. Verfahren nach Anspruch 22,
**dadurch gekennzeichnet, dass**
die Epitaxieoberfläche eine Oberfläche einer Nitridverbindungshalbleiterschicht (2) ist.

24. Verfahren nach Anspruch 22,
**dadurch gekennzeichnet, dass**
die Epitaxieoberfläche eine Oberfläche eines Substrats (1) ist.

25. Verfahren nach einem der Ansprüche 22 bis 24,
**dadurch gekennzeichnet, dass**
die Seitenfacette (9) der nicht planaren Struktur (4) schräg oder senkrecht zur Epitaxieoberfläche verläuft.

26. Verfahren nach einem der Ansprüche 22 bis 25,
**dadurch gekennzeichnet, dass**
die Maskenschicht (3) eine Mehrzahl parallel angeordneter streifenförmiger Öffnungen (11) aufweist.

27. Verfahren nach Anspruch 26,
**dadurch gekennzeichnet, dass**
die streifenförmigen Öffnungen (11) eine Breite b von 100 nm bis 10 µm aufweisen.

28. Verfahren nach Anspruch 26 oder 27,
**dadurch gekennzeichnet, dass**
die streifenförmigen Öffnungen (11) einen gegenseitigen Abstand d von 100 nm bis 200 *µ*m aufweisen.

29. Verfahren nach einem der Ansprüche 22 bis 28,
**dadurch gekennzeichnet, dass**
das Aufwachsen der nicht planaren Struktur (4) und der Quantentopfstruktur (5) mittels metallorganischer Gasphasenepitaxie (MOVPE) erfolgt.

30. Verfahren nach einem der Ansprüche 22 bis 29,
**dadurch gekennzeichnet, dass**
eine derart dicke Deckschicht (12) aufgebracht wird, dass sie eine planare Oberfläche aufweist.
